# EUROPÄISCHE PATENTSCHRIFT

(11) **EP 2 862 279 B1**
(45) Veröffentlichungstag und Bekanntmachung des Hinweises auf die Patenterteilung: **06.07.2016**
(21) Anmeldenummer: 13719767.9
(22) Anmeldetag: 19.04.2013
(51) Int. Cl.: H03K 21/08, H03K 21/40

(54) **DIGITALE ABTASTSCHALTUNG FÜR EIN MIT HILFE EINES PRIMÄR-TAKTSIGNALS AUF TAKTAUSFALL ZU ÜBERWACHENES SEKUNDÄR-TAKTSIGNAL**
DIGITAL SENSING CIRCUIT FOR A SECONDARY CLOCK SIGNAL TO BE MONITORED FOR CLOCK FAILURE WITH THE AID OF A PRIMARY CLOCK SIGNAL
CIRCUIT DE BALAYAGE NUMÉRIQUE POUR UN SIGNAL D'HORLOGE SECONDAIRE DONT UNE PANNE D'HORLOGE DOIT ÊTRE SURVEILLÉE À L'AIDE D'UN SIGNAL D'HORLOGE PRIMAIRE

(30) Priorität: 14.06.2012 DE 102012209971
(43) Veröffentlichungstag der Anmeldung: 22.04.2015
(73) Patentinhaber: AREVA GmbH, 91052 Erlangen (DE)
(72) Erfinder: AUER, Günther, 91052 Erlangen (DE); HEINEMANN, Bernd, 91052 Erlangen (DE)
(74) Vertreter: Kugler, Jörg
(86) Internationale Anmeldenummer: PCT/EP2013/058168
(87) Internationale Veröffentlichungsnummer: WO 2013/185960

(56) Entgegenhaltungen:
- WO-A1-2007/110099
- US-A- 5 479 420
- US-A1- 2005 242 852

## Beschreibung

Die Erfindung bezieht sich auf eine digitale Abtastschaltung für ein mit Hilfe eines Primär-Taktsignals auf Taktausfall zu überwachendes Sekundär-Taktsignal
- mit einem Flipflop, welches
   - einen Clock-Eingang,
   - einen Data-Eingang,
   - einen Q-Ausgang und
   - einen Reset-Eingang aufweist,
- und mit einem n-Bit-Zähler, welcher
   - einen Takt-Eingang,
   - einen Reset-Eingang und
   - einen Zählwert-Ausgang aufweist.

Verschiedene Taktsignale können bei gleicher Taktfrequenz gegeneinander phasenverschoben und insofern asynchron zueinander sein. Zum Erfassen und Abtasten eines Sekundär-Taktsignals, auch asynchrones Signal genannt, welches asynchron zu einem Primär-Taktsignal, auch Systemtakt genannt, verschoben ist, können beispielsweise Flipflops eingesetzt werden. Ein Flipflop ist allgemein eine elektronische Schaltung, die zwei stabile Zustände einnehmen kann und Daten mit der Menge von 1 Bit speichern kann, wobei Flipflops vielfach als Grundbausteine für sequentielle Schaltungen genutzt werden.

Bei taktgesteuerten Flipflops reagiert ein Flipflop nur zu bestimmten Zeiten auf die Eingangssignale, was insbesondere zweckmäßig ist, wenn die Eingangssignale nur in bestimmten Zeitabschnitten stabil anliegen. Oftmals wird hierzu ein Taktsignal verwendet, welches die Steuereingänge eines Flipflops in regelmäßigen Zeitabständen freischaltet bzw. durchstellt, so dass man in diesem Zusammenhang auch von einem Takt- bzw. Clock-Eingang spricht. So wird bei der Verwendung von D-Flipflops regelmäßig das Primär-Taktsignal an den Clock-Eingang, oder auch kurz C-Eingang, und das asynchrone Signal (Sekundär-Taktsignal) an den Data-Eingang, oder auch kurz D-Eingang, angelegt. Das asynchrone Eingangssignal wird bei Freischaltung des Steuereingangs an den Q-Ausgang weitergeleitet bzw. durchgestellt. In der Regel sind die Flipflops hierbei taktflankengesteuert (engl.: edge triggered), so dass beispielsweise eine positive Taktflanke eine Zustandsänderung auslöst, wobei die Taktfrequenz der Abtastfrequenz, also der Frequenz des Primär-Taktsignals, entspricht. Die Zeit zwischen zwei positiven Taktflanken wird in der Regel als Zykluszeit bezeichnet.

Bei dem beschriebenen Prozess in einem D-Flipflop gibt es mehrere Fälle, die zu Problemen führen können, und die sich wie folgt unterscheiden lassen:
Einerseits ist die Abtastfrequenz durch die Taktfrequenz des Primär-Taktsignals fest vorgegeben, so dass ein Pegel-Wechsel des asynchronen Signals nur dann erkannt wird, wenn der Pegel des asynchronen Signals zu den Abtastzeitpunkten verschieden ist. So wird beispielsweise ein Wechsel des Zustands mit Low-Pegel ("0") in den Zustand mit High-Pegel ("1") nicht erkannt, wenn ein erneuter Wechsel von "1" zu "0" erfolgt, bevor die nächste Taktflanke des synchronen Abtastsignals kommt. In anderen Worten gesprochen, wird der zwischenzeitliche Zustandswechsel an den Q-Ausgang nicht weitergegeben, wenn der zweimalige Wechsel des Zustands des asynchronen Signals innerhalb einer Zykluszeit erfolgt.

Neben diesem Mangel, der zunächst von der Taktfrequenz des synchronen Systems abhängt, kann ein weiteres Problem auftreten. Bei einer Änderung des asynchronen Signals, beispielsweise von "0" zu "1", während einer positiven Flanke des Taktsignals, kann ein metastabiler Zustand im Flipflop auftreten, so dass der Zustand des Flipflops und damit auch der Wert am Q-Ausgang undefiniert sind. Nach einer ebenfalls undefinierten bzw. unbekannten Zeit kann das Flipflop aus dem undefinierten Zustand wieder in einen definierten Zustand gelangen, wobei dies nicht der tatsächlich richtige Zustand, wie "0" oder "1", sein muss. Andererseits kann der metastabile Zustand für eine unbestimmte Zeit andauern. In beiden Fällen können hierdurch schwerwiegende Fehlfunktionen in nachfolgenden Systemen auftreten. Schaltungsbeispiele zur Überwachung von Taktsignalen sind z.B. in US 5,479,420 A1 und in WO 2007/110099 A1 beschrieben.

Durch das Hintereinanderschalten von mehreren synchron getakteten Abtast-Flipflops kann die Wahrscheinlichkeit des Auftretens von metastabilen Zuständen prinzipiell gesenkt werden. Bei hintereinandergeschalteten D-Flipflops könnte beispielsweise das Primär-Taktsignal an dem C-Eingang eines jeden Flipflops anliegen. Das asynchrone Signal würde an dem D-Eingang des ersten Flipflops anliegen, wobei dessen Q-Ausgang mit dem D-Eingang des nächsten, zweiten Flipflops verbunden wäre. Der Q-Ausgang des zweiten Flipflops wäre dann erneut mit dem D-Eingang des folgenden Flipflops verbunden usw.

In einem Kernkraftwerk finden solche Flipflops und deren elektrische Verschaltung unter anderem Verwendung bei der Überwachung und Eingliederung von Taktsignalen in sicherheitskritischen Baugruppen, die mehrfach redundant ausgelegt sind und somit auch redundante Taktsignale, die von verschiedenen Taktgebern stammen können, aufweisen können. So sind Steuerstäbe und deren Position im Reaktordruckbehälter regelmäßig zu überwachen. Die Steuerstäbe absorbieren insbesondere Neutronen und dienen somit der Steuerung des Neutronenflusses der Brennstäbe in einem Kernreaktor. Zur Unterbindung der Kettenreaktion in einem nuklearen Zerfallsprozess und um somit die nukleare Aktivität zu stoppen, werden diese regelmäßig vollständig in die Brennstäbe hineingefahren.

Zur Bestimmung der besonders sicherheitsrelevanten Position der Steuerstäbe findet in vielen Fällen ein Verfahren Anwendung, bei dem eine Anzahl von Primärspulen eine Anzahl von Sekundärspulen in Abhängigkeit der Steuerstabsposition unterschiedlich stark mit einer Wechselspannung erregt. Die Wechsel- bzw. Sinusspannungen für die Anregung der Spulen werden jeweils mit Hilfe eines entsprechenden Generators aus einem Taktsignal gebildet. Alle Spulen sollen möglichst von einer Sinusspannung mit gleicher Frequenz und Phasenlage angeregt werden. Deswegen ist die Synchronisierung der einzelnen Taktsignale besonders wichtig, um im Ergebnis eine hohe Zuverlässigkeit des Messsystems zu erreichen.

In diesem Zusammenhang kann die Frequenz der Wechselspannung als Taktfrequenz der Steuerung von Flipflops dienen, wobei die jeweilige Taktfrequenz der einzelnen Baugruppen im Stabstellungsmesssystem in seiner Gesamtheit synchronisiert werden soll. Da unter anderem bedingt durch Fertigungstoleranzen der Taktgeneratoren jede Baugruppe mit einer eigenen, von den anderen Baugruppen leicht abweichenden Taktfrequenz arbeitet, müssen Signalwechsel des zu überwachenden Taktsignals der jeweiligen Baugruppe unabhängig von der Phasenlage zum Systemtakt, repräsentiert durch das Primär-Taktsignal, detektiert werden, so dass eine Synchronizität mit anderen Schaltungsteilen hergestellt werden kann.

Trotz der Reduktion der Eintrittswahrscheinlichkeit eines metastabilen Zustands durch das oben beschriebene Hintereinanderschalten von synchron getakteten Flipflops ist es immer noch denkbar, dass auch in sicherheitskritischen Bereichen, wie Kernkraftwerken, schwerwiegende Systemfehler durch ein Erreichen von metastabilen Zuständen in Flipflops ausgelöst werden. Auch können mögliche, nichterkannte Zustandswechsel innerhalb einer Zykluszeit zu schwerwiegenden Fehlern führen.

Der Erfindung liegt daher die Aufgabe zugrunde, eine Abtastschaltung der eingangs genannten Art anzugeben, die einerseits ein Erreichen von metastabilen Zuständen vermeidet, und die andererseits zuverlässig auch kurzlebige Zustandswechsel des Sekundär-Taktsignals innerhalb einer Zykluszeit erkennt und sich somit zum Betreiben von sicherheitsrelevanten Baugruppen, die auch in Kernkraftwerken eingesetzt werden können, eignet.

Die Aufgabe wird erfindungsgemäß gelöst, indem das Flipflop und der n-Bit-Zähler elektrisch miteinander verschaltet sind, wobei
- n ≥ 2 ist,
- das Primär-Taktsignal am Takt-Eingang des n-Bit-Zählers anliegt
- das Sekundär-Taktsignal am Clock-Eingang des Flipflops anliegt,
- ein konstantes Signal am Data-Eingang des Flipflops anliegt,
- der Q-Ausgang des Flipflops mit dem asynchronen Reset-Eingang des n-Bit-Zählers verbunden ist, und
- der Zählwert-Ausgang des n-Bit-Zählers über ein zwischengeschaltetes Logik-Gatter und eine Rückkopplungsschleife derart mit dem asynchronen Reset-Eingang des Flipflops verbunden ist dass ein Reset des n-Bit Zählers das Flipflop zurücksetzt.

Vorteilhafte Ausgestaltungen sind Gegenstand der Unteransprüche.

Die Erfindung geht von der Überlegung aus, dass ein Flipflop, wie ein D-Flipflop, das in vielen Fällen für eine digitale Abtastschaltung der beschriebene Art Verwendung findet, in einen unerwünschten metastabilen Zustand gelangen kann, wenn eine Flanke des zu überwachenden asynchronen Taktsignals mit einer Flanke des Systemtakts zusammenfällt. Ein Hintereinanderschalten von synchron getakteten D-Flipflops reduziert zwar die Eintrittswahrscheinlichkeit, ändert aber nichts an dem grundsätzlichen Problem, so dass nach Alternativen gesucht wird. Um eine Nutzung von übermäßig vielen Flipflops und diesen zugeordneten Bauteilen zu vermeiden, wurde zudem erkannt, dass im Gegensatz zu dem bloßen Hintereinanderschalten von synchron getakteten D-Flipflops ein Rückkoppel-Mechanismus einen positiven Effekt besitzen kann. Überraschenderweise wurde dabei auch erkannt, dass das Primär-Taktsignal und das Sekundär-Taktsignal in getrennte Bauteile, wie separate Flipflops, eingespeist werden können, welche miteinander verschaltet sind, so dass eine funktionelle Trennung zwischen asynchronem und synchronem System durch die Verwendung von verschiedenen Bauteilen möglich ist. Dabei wurde ebenfalls erkannt, dass auch weiterhin ein Flipflop genutzt werden kann, sofern dieses mit einem weiteren, nachgelagerten Bauteil, wie einem n-Bit-Zähler (n-Bit-Counter), verschaltet wird und einen Reset-Eingang aufweist, durch den ein Rückkoppel-Mechanismus vom synchronen System zum asynchronen System bereitgestellt wird. Durch ein Zählen und Überwachen des am Takt-Eingang des n-Bit-Zählers anliegenden, wiederkehrenden Signals, dem Primär-Taktsignal, kann registriert werden, ob zwischenzeitlich ein Signal am Data-Eingang des Flipflops anliegt, welches an den (asynchronen) Reset-Eingang des n-Bit-Zählers weitergeleitet wird und ein Zurücksetzen des Zählwerts im n-Bit-Zähler auslöst.

Weiterhin hat sich gezeigt, dass das asynchrone Signal, das Sekundär-Taktsignal, auch an dem Clock-Eingang des Flipflops, an dem in der Regel ein primäres Takt-signal anliegt, anliegen kann, und dass ein konstantes Signal an dem Data-Eingang des Flipflops anliegen kann, so dass der Pegel des konstanten Signals an den Q-Ausgang weitergeleitet und an das synchrone System übergeben wird, sobald beispielsweise eine positive Taktflanke des asynchronen Signal erscheint.

Durch eine geeignete Rückkopplung mittels eines Logik-Gatters zu dem (asynchronen) Reset-Eingang des Flipflops kann dabei der Zählwert des n-Bit-Zählers, der am Zählwert-Ausgang vorliegt, das Flipflop und damit dessen Q-Ausgang zurücksetzen. Sobald der n-Bit-Zähler erneut durch eine positive Flanke des Primär-Taktsignals inkrementiert wurde, kann wieder eine Flanke des Sekundär-Taktsignals detektiert werden.

Bei dem synchronen System kann somit durch den n-Bit-Zähler ein Abgleich mit dem Primär-Taktsignal erreicht werden, wobei das Primär-Taktsignal den Zählvorgang auslöst, der zurückgesetzt wird, sobald der konstante Pegel, welcher am Data-Eingang des Flipflops anliegt, an dessen Q-Ausgang weitergleitet wird, und zwar durch das Sekundär-Taktsignal. Ein mehrfaches Hochzählen des Taktsignals am n-Bit-Zähler bis zu einem definierten Wert hin, insbesondere bis zum Endwert des Zählers, ohne zwischenzeitliches Zurücksetzen entspricht somit einem Taktausfall, der gemeldet werden soll. Dabei kann insbesondere die von synchron getakteten Abtast-Systemen bekannte und dort auf die beschriebenen Signalzeitprobleme zurückgehende Störanfälligkeit vermieden werden.

Um die Überwachung der Primär- und Sekundärtaktsignale an systembedingte Signale anzupassen, sind in vorteilhafter Ausgestaltung das Flipflop und der n-Bit-Zähler flankengesteuert, insbesondere einflankengesteuert, insbesondere vorderflankengesteuert (das heißt, durch positive Taktflanken getriggert).

Für einen bewussten Verzicht auf weitere Funktionen, die kompliziertere Typen von Flipflops ermöglichen, die aber auch Fehlerquellen darstellen können, ist das Flipflop, welches das Sekundär-Taktsignal aufnimmt, vorzugsweise als D-Flipflop ausgestaltet.

In vorteilhafter Ausgestaltung ist das Logik-Gatter ein NOR-Gatter, an welchem eingangsseitig die Stellenwert-Bits des Zählwert-Ausgangs anliegen, wodurch der Zählwert des n-Bit-Zählers in geeigneter und einfach gehaltener Weise mit dem Reset-Eingang des Flipflops verschaltet werden kann.

Für eine Meldung und insbesondere eine visuelle Darstellung eines Taktausfalls bzw. auch des Normalverlaufs ist in vorteilhafter Ausgestaltung der Zählwert-Ausgang des n-Bit-Zählers über ein weiteres Logik-Gatter mit einem Alarmsignalgeber, der insbesondere eine Anzeigeeinheit umfasst, verbunden. Dem Bedienpersonal kann hierdurch ein Taktausfall gemeldet und/oder angezeigt werden, so dass ein Eingreifen zügig geschehen kann.

Vorteilhafterweise ist das weitere Logik-Gatter ein AND-Gatter, an welchem eingangsseitig die Stellenwert-Bits des Zählwert-Ausgangs anliegen, so dass bei Erreichen eines definierten Zählwerts, nämlich vorteilhafterweise des Zähler-Endwerts, der Alarmsignalgeber aktiv wird.

In vorteilhafter Ausgestaltung weisen das Primär-Taktsignal und das Sekundär-Taktsignal im Wesentlichen die gleiche Taktperiodendauer auf, wobei aber geringfügige Abweichungen, etwa im einstelligen Prozentbereich, und demzufolge eine Phasendrift aufgrund der unvermeidlichen Fertigungstoleranzen der zugrunde liegenden Taktgeber zulässig sind.

Für eine kompakte und einfache Ausgestaltung des n-Bit-Zählers ist dieser vorteilhafterweise als 2-Bit-Zähler ausgestaltet (n = 2), wodurch bereits bei kurzem Ausbleiben des Sekundär-Taktsignals der maximale Zählwert erreicht wird. Falls ein Alarm erst bei höheren Zählwerten ausgelöst werden soll, etwa bei 10 ausgefallenen Takten, ist die Bit-Tiefe des Zählers entsprechend zu wählen.

Um auf zusätzliche elektronische Hilfsmittel zu verzichten, weisen das Flipflop und der n-Bit-Zähler vorteilhafterweise im Wesentlichen gleiche Low- und High-Pegel auf. Hierdurch können Ausgänge des einen Bauteils mit Eingängen des anderen Bauteils direkt verbunden werden, ohne dass elektrische Mittel zur Pegelangleichung verwendet werden müssen, wodurch die elektrische Verschaltung einfach gehalten werden kann.

Um einen gängigen n-Bit-Zähler zu nutzen, ist in weiterer vorteilhafter Ausgestaltung das D-Flipflop derart ausgestaltet, dass ein Signal mit High-Pegel, welches am Reset-Eingang anliegt, ein Zurücksetzen des Signals am Q-Ausgang bewirkt. Dies kann durch Erreichen eines High-Pegels am Ausgang des dem n-Bit-Zähler des synchronen Systems nachgeschalteten Logik-Gatters ausgelöst werden. Solange der High-Pegel am Reset-Eingang des Flipflops anliegt, wird ein Durchschalten des am D-Eingang des Flipflops anliegenden Eingangssignals zum Q-Ausgang bei einer positive Taktflanke verhindert, sprich das Flipflop wird dann gewissermaßen nicht scharf geschaltet.

Eine kerntechnische Anlage, insbesondere ein Kernkraftwerk, mit einem Überwachungssystem mit mehreren Mastertaktsignalen, welches mehrfach redundant ausgelegte Baugruppen mit jeweils mindestens einem Taktgenerator aufweist, weist vorteilhafterweise zumindest eine beschriebene Abtastschaltung je Mastertaktsignal auf, um diese auf Taktausfall zu überwachen.

Vorteilhafterweise sind die Taktgeneratoren in der kerntechnischen Anlage von gleicher Bauart, so dass die von den Taktgeneratoren erzeugten Takte nur geringe Frequenz-Unterschiede aufweisen und eine geringere Störanfälligkeit besitzen.

In weiterer vorteilhafter Ausgestaltung ist das Überwachungssystem für die Positionsmessung von Kernreaktor-Steuerstäben ausgebildet.

Um die Abtastschaltung in sicherheitskritische Systeme mit bestehenden Taktzeiten zu integrieren, weist das Taktsignal in vorteilhafter Ausgestaltung eine Frequenz zwischen 120 und 10 Hertz, bei bestehenden Anwendungen im nuklearen Umfeld beispielsweise 31 Hertz auf, wobei die Komponenten der Abtastschaltung auf diese Frequenz abgestimmt sind.

Insbesondere bei einem Kernkraftwerk, welches hohen Sicherheitserfordernissen genügen sollte, ist es in vorteilhafter Ausgestaltung vorgesehen, dass zumindest eine Baugruppe des Steuerstabstellungsmesssystems eine der genannten Abtastschaltungen aufweist, so dass die Störanfälligkeit im Hinblick auf Taktausfälle reduziert werden kann.

Die mit der Erfindung erzielten Vorteile bestehen insbesondere darin, dass durch die Kombination eines Flipflops mit einem n-Bit-Zähler eine digitale Abtastschaltung für zu einem Primär-Taktsignal asynchrone Sekundär-Taktsignale geschaffen wird, bei der das Taktsignal und das hierzu asynchrone Signal unterschiedlichen Verarbeitungskomponenten zugeführt werden, welche durch eine geeignet gewählte Verschaltung zueinander einen Taktausfall nahezu störungsfrei registrieren können. Insbesondere durch den Einsatz eines Flipflops, an dem ein asynchrones Signal anliegt, und einen n-Bit-Zähler, an dem das Primär-Taktsignal anliegt, sowie einer elektrischen Verschaltung mit Rückkopplung der beiden Komponenten kann dem Sicherheitsgedanken in einem Kernkraftwerk durch eine wohldefinierte und ausfallfreie Überwachung der Sekundär-Taktsignale Rechnung getragen werden.

Ein Ausführungsbeispiel der Erfindung wird nachfolgend anhand einer Zeichnung erläutert. Darin zeigen in jeweils vereinfachter schematischer Darstellung:
- FIG. 1: eine Abtastschaltung mit einem D-Flipflop und mit einem 2-Bit-Zähler,
- FIG. 2: ein Zeitdiagramm für Taktsignal, asynchrones Signal, Q-Wert des Flipflops sowie Zählwert des 2-Bit-Zählers bei einer Abtastschaltung nach FIG. 1,
- FIG. 3: eine kerntechnische Anlage mit einem auf der Abtastschaltung gemäß FIG. 1 beruhenden Taktsynchronisierungssystem als eine erste Anwendung, und
- FIG. 4: eine zweite Anwendung der Abtastschaltung gemäß FIG. 1 in einem Taktsynchronisierungssystem einer kerntechnischen Anlage.

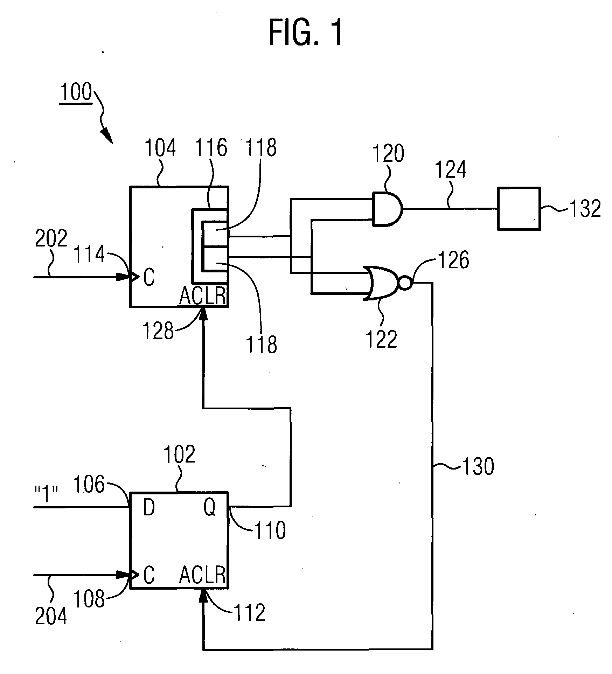

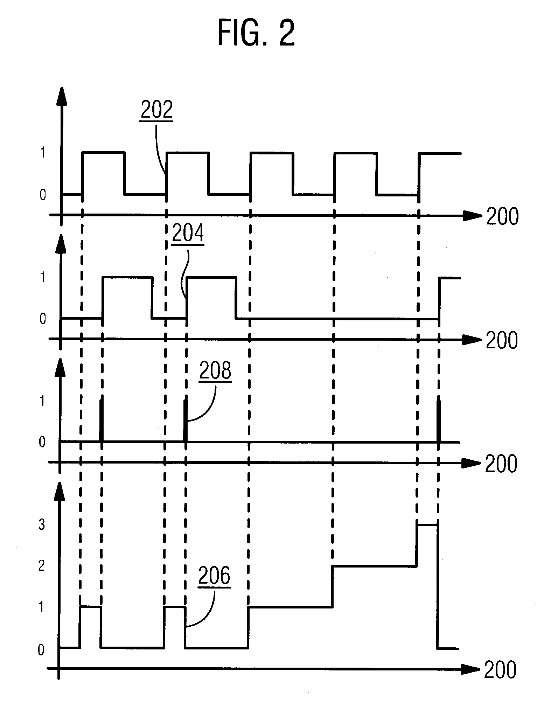

Die in FIG. 1 dargestellte Abtastschaltung 100 besteht unter anderem aus einem D-Flipflop 102 und einem 2-Bit-Zähler 104, die elektrisch miteinander verschaltet sind. An dem 2-Bit-Zähler 104 liegt dabei eingangsseitig ein in FIG. 2 als Funktion der Zeit dargestelltes periodisches Taktsignal 202 an, welches auch als synchrones Signal oder Primär-Taktsignal bezeichnet wird. An dem D-Flipflop 102 liegt ein ebenfalls in FIG.2 dargestelltes, asynchrones Signal 204 an, welches normalerweise die gleiche Frequenz wie das Taktsignal 202 besitzt, dessen Phase aber im Allgemeinen - wie hier dargestellt - gegenüber dem Taktsignal 202 verschoben ist. Das asynchrone Signal 204 wird auch als Sekundär-Taktsignal bezeichnet.

Das D-Flipflop 102 weist einen Data-Eingang 106 (kurz: D-Eingang), einen Clock-Eingang 108 (kurz: C-Eingang), einen Q-Ausgang 110 und einen asynchronen Reset- bzw. Clear-Eingang, auch ACLR 112 genannt, auf.

Am Data-Eingang 106 liegt ein konstantes Signal mit einem High-Pegel, auch als "1" bezeichnet, dem beispielsweise eine elektrische Spannung von ungefähr 5 Volt entspricht, an. Dem Clock-Eingang 108 wird über eine mit ihm verbundene elektrische Leitung das asynchrone Signal 204 zugeführt. Im Ausgangszustand weist der Q-Ausgang 110 einen Low-Pegel auf, der einem Wert von "0" entspricht, auf. Sobald eine positive Taktflanke des asynchronen Signals 204 den Clock-Eingang 108 erreicht, wird das konstante Signal, welches am Data-Eingang 106 anliegt, an den Q-Ausgang 110 weitergegeben bzw. durchgestellt, so dass sich der in FIG. 2 als Funktion der Zeit dargestellte Q-Wert 208 ausgehend vom Ausgangszustand "0" auf "1" ändert.

Ein Reset des D-Flipflops 102, bei dem das Signal am Q-Ausgang 110 zurückgesetzt wird, wird durch den ACLR 112 bewirkt (asynchroner Reset). Das heißt, bei einem High-Pegel "1", der am ACLR 112 anliegt, wird der Wert am Q-Ausgang 110 wieder auf den Ausgangswert, nämlich den Low-Pegel "0" zurückgesetzt, dem beispielsweise eine elektrische Spannung von 0 bis 0,5 Volt entspricht. Weiterhin wird das D-Flipflop 102, solange ein Wert "1" an dem asynchronen Reset-Eingang ACLR 112 anliegt, nicht den Wert "1" am Data-Eingang 106 bei einer positiven Flanke des asynchronen Taktsignals 204 auf den Q-Ausgang 110 durchschalten, sondern der Q-Ausgang 110 wird auch weiterhin den Wert "0" ausgeben.

Das D-Flipflop 102 ist mit dem 2-Bit-Zähler 104 elektrisch verschaltet. Der 2-Bit-Zähler 104, der beispielsweise aus zwei JK-Flipflops zusammengesetzt sein kann, zählt positive Taktflanken, die an dessen Takt-Eingang 114, der teilweise auch Clock- oder Zähl-Eingang genannt wird, gelangen. Bei einem n-Bit-Zähler ist allgemein die Anzahl der möglichen Zählwerte auf Zweierpotenzen festgelegt und geht von 0 bis 2ⁿ-1, so dass bei einem 2-Bit-Zähler die Zahlen Null, Eins, Zwei und Drei (0, 1, 2, 3) erzeugt bzw. gezählt werden können, die dem am Zählwert-Ausgang 116 anliegenden Zählwert 206 entsprechen, welcher in FIG. 2 in Dezimaldarstellung als Funktion der Zeit abgebildet ist.

Der Zählwert-Ausgang 116 umfasst ein 2-Bit-Register 118, das den aktuellen Zählwert 206 in Binärdarstellung enthält. Dem 2-Bit-Register 118 datenseitig nachgeschaltet sind einerseits ein AND-Gatter 120 und andererseits ein NOR-Gatter 122. Das AND-Gatter 120 verknüpft die beiden Stellenwerte bzw. Bits des 2-Bit-Registers 118 gemäß der logischen AND-Operation ("&"), so dass der am Ausgang 124 anliegende Wert den Low-Pegel "0" annimmt, wenn der 2-Bit-Zähler 104 einen der Zählwerte 206 Null, Eins oder Zwei (0, 1, 2) besitzt, und den High-Pegel "1" bei dem Zählwert 206 Drei (3). Der am Ausgang 126 des NOR-Gatters 122 anliegende Wert hingegen nimmt gemäß der logischen NOR-Operation (NOT-OR) nur dann den High-Pegel "1" an, wenn der 2-Bit-Zähler 104 den Zählwert 206 Null (0) besitzt, ansonsten den Low-Pegel "0".

An dem Takt-Eingang 114 des 2-Bit-Zählers 104 liegt das synchrone Taktsignal 202 an, welches hier im Ausführungsbeispiel eine Frequenz von 31 Hertz aufweist. Die in FIG. 2 mit durchgezogener Linie dargestellten, für die Steuerung der elektronischen Komponenten maßgeblichen Pegelwechsel des synchronen Taktsignals 202 entsprechen - wie durch die gestrichelten Linien angedeutet ist - beispielsweise den positiven Flanken eines periodischen Rechteck-Signals, sprich einem Übergang eines Low-Pegels "0" in den High-Pegel "1", der mit der festen Frequenz von 31 Hertz erfolgt. Die Periodendauer wird auch als Zykluszeit bezeichnet. In entsprechender Weise können die maßgeblichen Pegelwechsel des asynchronen Signals 204 als positive Taktflanken eines Rechteck-Trägersignals aufgefasst werden, wobei insbesondere die Verweildauer im High-Pegel-Zustand "1" beim asynchronen Signal 204 kürzer sein kann als beim synchronen Taktsignal 202.

Der 2-Bit-Zähler 104 zählt dabei die positiven Taktflanken des synchronen Taktsignals 202, sofern der 2-Bit-Zähler 104 nicht zurückgesetzt wird. Das Zurücksetzen geschieht durch ein elektrisches Signal, welches an einen asynchronen Reset- oder Clear-Eingang ACLR 128 des 2-Bit-Zählers 104 gelangt. Hierzu liegt bei der elektrischen Verschaltung zwischen D-Flipflop 102 und 2-Bit-Zähler 104 der Q-Ausgang 110 an dem ACLR 128 beim 2-Bit-Zähler 104 an. Durch einen High-Pegel "1" (Reset-Signal) am ACLR 128, der durch das Auftreten einer positiven Taktflanke des asynchronen Signals 204 am Clock-Eingang 108 über die Weiterleitung des High-Pegels "1" vom Data-Eingang 106 zu dem Q-Ausgang 110 und somit zu dem ACLR 128 erzeugt wird, wird der 2-Bit-Zähler 104 zurückgesetzt. Das heißt, die durch positive Taktflanken am Takt-Eingang 114 getriggerte Zählung geht beim Zählwert 206 Null (0) von vorne los, sobald das Reset-Signal nicht mehr anliegt.

Die Abtastschaltung 100 weist zudem eine Rückkopplung auf. Zu diesem Zweck ist der Zählwert-Ausgang 116 des 2-Bit-Zählers 104 über das zwischengeschaltete NOR-Gatter 122 und den Ausgang des NOR-Gatters 126 mit dem Reset-Eingang ACLR 112 des D-Flipflops 102 signalmäßig verbunden. Bei einem Reset-Signal an dem ACLR 128, welches wie oben beschrieben durch das asynchrone Taktsignal 204 ausgelöst wird, wird zunächst der 2-Bit-Zähler 104 auf den Zählwert 206 Null (0) zurückgesetzt. Unmittelbar wird dann auch das D-Flipflop 102 zurückgesetzt, und zwar durch die Weitergabe des Signals über das NOR-Gatter 122 und die Rückkopplungsschleife 130 an den ACLR 112 des D-Flipflops 102. Dieser Vorgang setzt den Wert am Q-Ausgang 110 auf den Low-Pegel "0" zurück. Da das Rücksetzen des Q-Werts 208 durch die Rückkopplung mit sehr geringer zeitlicher Verzögerung (quasi instantan) gegenüber dem Eingangssignal erfolgt, nimmt der Q-Wert 208 jeweils nur für eine sehr kurze Zeitspanne den High-Pegel "1" an, so dass das entsprechende zeitliche Signal - solange kein Taktausfall des asynchronen Signals 204 vorliegt - die in FIG. 2 im linken Bereich dargestellte periodische Peakstruktur besitzt.

Ausgehend von dem Grundzustand des Zählwerts 206 des 2-Bit-Zählers 104, welcher der Zahl Null (0) entspricht, wird der Endwert, welcher der Zahl Drei (3) entspricht, nur dann erreicht, wenn das synchrone Taktsignal 202 am Takt-Eingang 114 des 2-Bit-Zählers 104 dreimal in Folge den Zählwert 206 bis zum Endwert Drei (3) erhöht, sofern kein zwischenzeitliches Zurücksetzen des 2-Bit-Zählers 104 durch ein Auftreten des asynchronen Signals 204 erfolgt. Normalerweise wird also der 2-Bit-Zähler 104 bei jedem Zyklus durch das asynchrone Signal 204 aufs Neue in den Grundzustand zurückgesetzt. Bei einem Taktausfall des asynchronen Signals 204 erfolgt jedoch kein zwischenzeitliches Zurücksetzen des 2-Bit-Zählers 104; das heißt, der 2-Bit-Zähler 104 wird nicht am Hochzählen gehindert.

Auf diese Weise ist eine Überwachung des asynchronen Signals 204 auf Taktausfall möglich. Beim Erreichen des Endwerts Drei (3) des 2-Bit-Zählers 104, hervorgerufen durch einen dreimaligen Taktausfall des asynchronen Signals 204, wechselt der Zustand am Ausgang 124 des AND-Gatters 120 vom Low-Pegel "0" zum High-Pegel "1", was definitionsgemäß als Warnsignal interpretiert und in einer Anzeigeeinheit 132 dargestellt wird, so dass eine bedienerseitige Kontrolle und ggf. ein korrigierender Systemeingriff erfolgen können.

Sollte der Takt des asynchronen Signals 204 zu einem beliebigen Zeitpunkt (vor oder nach Erreichen des Zähler-Endwerts) aber wieder einsetzen, so ist die Abtastschaltung 100 wiederanlauffähig in dem Sinne, dass durch eine positive Taktflanke der am D-Eingang 106 des Flipflops 102 anliegende High-Pegel "1" an den Q-Ausgang 110 durchgeschaltet wird und die oben beschriebenen Vorgänge von vorne beginnen. Es ist also kein manueller Reset der Schaltung erforderlich.

Zusammengefasst geschieht also ausgehend von einem Zustand, bei dem der 2-Bit-Zähler 104 auf dem Zählwert Eins, Zwei oder Drei (1, 2 oder 3) steht und der Q-Ausgang 110 des Flipflops 102 den Wert "0" ausgibt, chronologisch folgendes, solange das sekundäre (asynchrone) Taktsignal 204 nicht ausfällt:
1. Eine positive Flanke des sekundären Taktsignals 204 tritt auf und schaltet die "1" am D-Eingang 106 des Flipflops 102 auf den Q-Ausgang 110 durch.
2. Die "1" am Q-Ausgang 110 des Flipflops 102 wirkt unmittelbar auf den asynchronen Reset-Eingang 128 des Zählers 104 und setzt diesen sofort auf den Zählwert Null (0) zurück.
3. Durch den Ausgabe- bzw. Zählwert Null (0) des Zählers 104 ist die NOR-Bedingung des NOR-Gatters 122 erfüllt, dessen Ausgabewert folglich sofort auf den Wert "1" wechselt.
4. Der Ausgabewert "1" des NOR-Gatters 122 wirkt unmittelbar auf den asynchronen Reset-Eingang 112 des Flipflops 102 und setzt dessen Q-Ausgang 110 auf den Wert "0".
5. Damit liegt am asynchronen Reset-Eingang 128 des Zählers 104 wieder eine "0" an, und er kann bei der nächsten positiven Flanke des primären Taktsignals 202 auf den Zählwert Eins (1) wechseln.
6. Eine positive Flanke des primären Taktsignals 202 tritt auf und setzt den Zähler 104 auf den Zählwert Eins (1),
7. Durch den Ausgabe- bzw. Zählwert Eins (1) des Zählers 104 ist die NOR-Bedingung des NOR-Gatters 122 nicht mehr erfüllt, dessen Ausgabewert folglich sofort auf den Wert "0" wechselt.
8. Das Flipflop 102 ist wieder bereit, um bei der nächsten positiven Flanke des sekundären Taktsignals 204 die "1" am D-Eingang des Flipflops 102 auf den Q-Ausgang 110 durchzuschalten.
9. Die Vorgänge beginnen wieder bei 1.

Fällt jedoch das asynchrone Taktsignal 204 aus, so kommt es in der oben beschriebenen Weise zur Erhöhung des Zählerstandes des Zählers 104 bis maximal zum Zählwert Drei (3), und der Taktausfall wird mit Hilfe des AND-Gatters 120 erkannt.

Wie bereits erwähnt, ist in FIG. 2 ein Zeitdiagramm dargestellt, in welchem die einzelnen Signale und deren Wechselwirkungen dargestellt sind.

Die Abszisse entspricht dabei der Zeitachse 200. Die verschiedenen elektrischen bzw. logischen Signale sind als Ordinaten aufgetragen, wobei dies von oben nach unten das Taktsignal 202, das asynchrone Signal 204, der Wert des Q-Ausgangs 110, hier Q-Wert 208 genannt, und der Zählwert 206 des 2-Bit-Zählers 104 sind.

Ändert das Taktsignal 202 seinen Wert vom Low-Pegel "0" auf den High-Pegel "1", wird die positive Taktflanke vom 2-Bit-Zähler 104 registriert und dessen Zählwert 206 ändert sich zunächst ausgehend von Null (0) zu Eins (1). Bei einer positiven Taktflanke des asynchronen Signals 204, gleichbedeutend mit einem Durchschalten des Werts "1" am Data-Eingang 106 zum Q-Ausgang 110 des D-Flipflops 102, wird der Q-Wert 208 von "0" auf "1" gesetzt. Dies löst auf Grund der elektrischen Verschaltung zwischen Q-Ausgang 110 des D-Flipflops 102 und ACLR 128 des 2-Bit-Zählers 104 einen Reset des 2-Bit-Zählers 104 aus, was eine Rücksetzung des Zählwerts 206 auf Null (0) zur Folge hat. Der Zählwert-Ausgang 116 setzt dann über das NOR-Gatter 122 und die Rückkopplungsschleife 130 das D-Flipflop 102 unmittelbar von "1" auf "0" zurück, und die Vorgänge beginnen von neuem.

Bleiben die positiven Flanken des asynchronen Signals 204 aus, während mehrere positive Flanken des synchronen Taktsignals 202 den 2-Bit-Zähler 104 erreichen, wird der Zählwert 206 vom Grundwert Null (0) ausgehend bis zum Endwert Drei (3) erhöht und damit ein Taktausfall des asynchronen Systems erkannt und über die zugehörige Anzeigeeinheit 132 signalisiert.

Es gibt eine alternative Variante der Abtastschaltung, die nicht auf Flanken des zu überwachenden Taktsignals reagiert, sondern auf dessen Pegel. Hierzu wird das Flipflop im Vergleich zu der bevorzugten Variante gemäß FIG. 1 anders beschaltet (nicht eigens in den Zeichnungen dargestellt):
Am Data-Eingang 106 des Flipflops 102 liegt ein konstantes Signal mit High-Pegel an. Das Primär-Taktsignal 202 liegt am Clock-Eingang 108 des Flipflops an, so dass das Flipflop 102 bei jeder steigenden Flanke den High-Pegel auf den Q-Ausgang 110 übernimmt. Der Reset-Eingang 112 des Flipflops 102 ist mit dem zu überwachenden Sekundär-Taktsignal 204 verbunden. Ein High-Pegel des zu überwachenden Sekundär-Taktsignals 204 erzeugt somit einen Low-Pegel am Q-Ausgang 110 des Flipflops 102. Der Q-Ausgang 110 des Flipflops 102 ist über einen Inverter mit dem Reset-Eingang 128 des n-Bit-Zählers 104 verbunden, welcher eingangsseitig mit dem Primär-Taktsignal 202 beaufschlagt ist. Somit bewirkt ein High-Pegel des zu überwachenden Sekundär-Taktsignals 204 ein Rücksetzen des n-Bit-Zählers 104. Die Ausgänge des n-Bit-Zählers 104 werden auf ein AND-Gatter geführt, so dass bei Erreichen des Endwerts des Zählers ein Taktausfall gemeldet wird.

Diese alternative Variante hat jedoch einen Nachteil: Fällt das zu überwachende Sekundär-Taktsignal 204 in der Weise aus, dass es dauerhaft auf einem High-Pegel stehen bleibt, so wird der Q-Ausgang 110 des Flip-Flops 102 dauerhaft auf Low-Pegel gehalten, was wiederum über den Inverter einen dauerhaften High-Pegel am Reset-Eingang 128 des n-Bit-Zählers 104 bewirkt.

Es kann also passieren, dass diese alternative Variante der Abtastschaltung durch den Ausfall des zu überwachenden Taktsignals außer Funktion gesetzt wird.

Um diesen Nachteil zu umgehen, werden für jedes zu überwachende Taktsignal zwei derartige Abtastschaltungen benötigt, wobei eine das Taktsignal auf Low-Pegel und die andere das Taktsignal auf High-Pegel überwacht. Die Taktausfallmeldungen der beiden Abtastschaltungen werden über ein OR-Gatter zu einer einzigen Taktausfallmeldung zusammengefasst. Somit kann auch mit dieser Variante der Abtastschaltung in jedem Fall ein Ausfall des Sekundär-Taktsignals erkannt werden.

Jedoch werden für diese alternative Variante doppelt so viele Ressourcen und ein zusätzliches OR-Gatter im Vergleich mit der zuvor beschriebenen bevorzugten Variante benötigt.

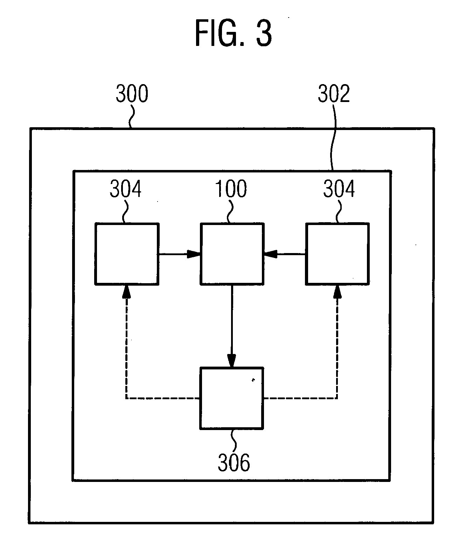

Eine erste mögliche Anwendung der Abtastastschaltung 100 gemäß FIG. 1 ist in FIG. 3 schematisch dargestellt: In einer kerntechnischen Anlage 300, insbesondere in einem Kernkraftwerk, ist ein digitales Überwachungssystem 302 mit redundant ausgeführten Baugruppen vorgesehen. Jede der Baugruppen weist einen Taktgenerator 304 gleicher Bauart auf. Die von je zwei der Taktgeneratoren 304 erzeugten Taktsignale werden einer Abtastschaltung 100 der oben beschriebenen Art zugeführt, wobei eines der Taktsignale als Master- oder Primärtakt behandelt wird, und das andere, durch Phasendrift und andere Einflüsse asynchron verschobene Taktsignal als Slave- oder Sekundärtakt behandelt wird. Mit Hilfe der Abtastschaltung 100 werden Taktausfälle der Slave-Baugruppe erkannt und an eine Steuereinheit 306 gemeldet, die gegebenenfalls auf die einzelnen Baugruppen, insbesondere auf deren Taktgeneratoren 304 zurückwirkt (angedeutet durch die gestrichelten Linien), um eine Taktsynchronisierung zu erreichen oder wiederherzustellen. Die Abtastschaltung 100 kann daher in Verbindung mit der Steuereinheit 306 als Taktsynchronisierungssystem für die Taktgeneratoren 304 aufgefasst werden. Anstelle eines gegenseitigen Abgleichs der redundanten Baugruppen untereinander kann auch ein Abgleich mit einem externen Taktgeber vorgesehen sein.

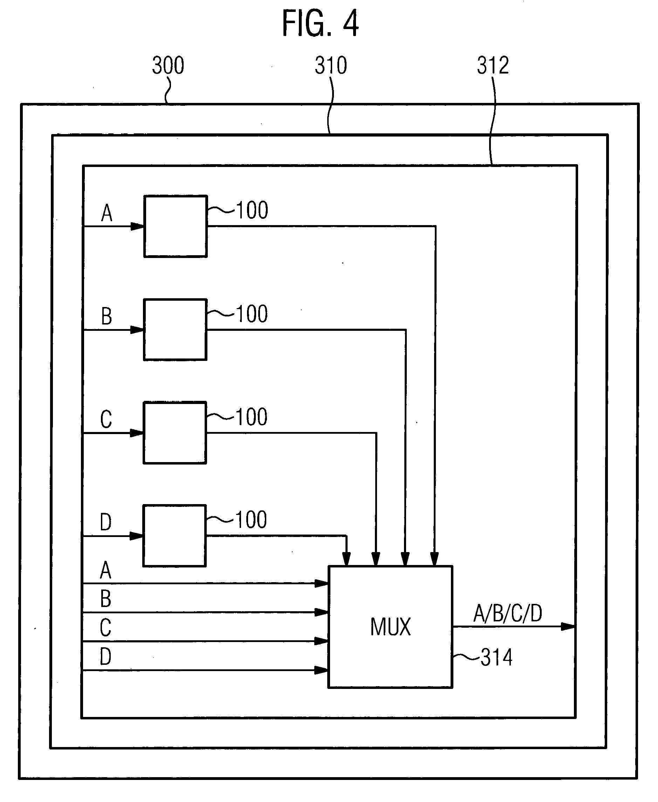

Eine zweite mögliche Anwendung ist in FIG. 4 schematisch dargestellt: In einer kerntechnischen Anlage 300, insbesondere in einem Kernkraftwerk, ist ein digitales Taktsynchronisierungssystem 310 mit beispielsweise vier redundanten Mastertaktsignalen A, B, C, D vorgesehen. Aufgabe des Systems ist es, genau ein Mastertaktsignal auf alle nachgeschalteten Komponenten weiterzuleiten, so dass diese absolut synchron arbeiten. Bei Ausfall des ersten Mastertaktsignals sollen die nachgeschalteten Komponenten mit einem zweiten Mastertaktsignal versorgt werden, so dass diese weiterhin absolut synchron arbeiten. Fällt auch noch das zweite Mastertaktsignal aus, soll auf ein drittes Mastertaktsignal umgeschaltet werden usw.

Jede der Baugruppen 312 wird mit mehreren, hier vier extern eingespeisten Mastertaktsignalen A, B, C, D versorgt, wobei die Auswahl des weiterzuleitenden Mastertaktsignals prioritätsgesteuert erfolgt. Innerhalb jeder Baugruppe 312 gibt es für jedes dieser Taktsignale A, B, C, D eine Abtastschaltung 100, die jeweils einen 2-Bit-Zähler beinhaltet. Ein Mastertaktsignal entspricht jeweils dem von einer Abtastschaltung 100 zu überwachenden Sekundär-Taktsignal. Das Primär-Taktsignal für die Zählvorgänge der 2-Bit-Zähler 104 wird intern von jeder Baugruppe durch einen hier nicht im Detail dargestellten internen Taktgeber generiert.

Die Mastertaktsignale A, B, C, D werden zusätzlich innerhalb jeder Baugruppe auf einen Multiplexer 314 geführt, der anhand der Taktausfallmeldungen der Abtastschaltungen 100 prioritätsgesteuert das weiterzuleitende Mastertaktsignal auswählt.

Sind alle Mastertaktsignale aktiv, wird das erste Mastertaktsignal weitergeleitet. Ist das erste Mastertaktsignal ausgefallen, jedoch das zweite Mastertaktsignal noch aktiv, wird das zweite Mastertaktsignal weitergeleitet. Sind sowohl das erste als auch das zweite Mastertaktsignal ausgefallen und ist das dritte Mastertaktsignal noch aktiv, wird das dritte Mastertaktsignal weitergeleitet usw.

Durch ein solches Taktsynchronisierungssystem 310 mit vier Mastertaktsignalen ist somit die Funktion und Synchronisierung der nachgeschalteten Komponenten auch noch bei einem Ausfall von drei der vier Mastertaktsignale gegeben.

Selbstverständlich können derartige Taktsynchronisierungssysteme auch in Zusammenhängen außerhalb des nuklearen Umfelds, etwa bei der industriellen Prozess- bzw. Maschinenüberwachung und Steuerung zum Einsatz kommen.

### Bezugszeichenliste

- 100: Abtastschaltung
- 102: D-Flipflop
- 104: 2-Bit-Zähler
- 106: Data-Eingang
- 108: Clock-Eingang
- 110: Q-Ausgang
- 112: ACLR
- 114: Takt-Eingang
- 116: Zählwert-Ausgang
- 118: 2-Bit-Register
- 120: AND-Gatter
- 122: NOR-Gatter
- 124: Ausgang des AND-Gatters
- 126: Ausgang des NOR-Gatters
- 128: ACLR
- 130: Rückkopplungsschleife
- 132: Anzeigeeinheit
- 200: Zeitachse
- 202: synchrones Taktsignal (Primär-Taktsignal)
- 204: asynchrones Signal (Sekundär-Taktsignal)
- 206: Zählwert
- 208: Q-Wert
- 300: kerntechnische Anlage
- 302: Überwachungssystem
- 304: Taktgenerator
- 306: Steuereinheit
- 310: Taktsynchronisierungssystem
- 312: Baugruppe
- 314: Multiplexer

- A, B, C, D: Master-Taktsignale

## Patentansprüche

1. Digitale Abtastschaltung (100) für ein mit Hilfe eines Primär-Taktsignals (202) auf Taktausfall zu überwachendes Sekundär-Taktsignal (204)
• mit einem Flipflop (102), welches
- einen Clock-Eingang (108),
- einen Data-Eingang (106),
- einen Q-Ausgang (110) und
- einen asynchronen Reset-Eingang (112) aufweist,
• und mit einem n-Bit-Zähler (104), welcher
- einen Takt-Eingang (114),
- einen asynchronen Reset-Eingang (128) und
- einen Zählwert-Ausgang (116) aufweist,
wobei das Flipflop (102) und der n-Bit-Zähler (104) elektrisch miteinander verschaltet sind, und wobei
• n ≥ 2 ist,
• das Primär-Taktsignal (202) am Takt-Eingang (114) des n-Bit-Zählers (104) anliegt,
• das Sekundär-Taktsignal (204) am Clock-Eingang (108) des Flipflops (102) anliegt,
• ein konstantes Signal am Data-Eingang (106) des Flipflops (102) anliegt,
• der Q-Ausgang (110) des Flipflops (102) mit dem Reset-Eingang (128) des n-Bit-Zählers (104) verbunden ist, dadurch characterisiert, daß
• der Zählwert-Ausgang (116) des n-Bit-Zählers (104) über ein zwischengeschaltetes Logik-Gatter (122) und eine Rückkopplungsschleife (130) derart mit dem asynchronen Reset-Eingang (112) des Flipflops (102) verbunden ist, dass ein Reset des n-Bit-Zählers (104) das Flipflop (102) zurücksetzt.

2. Abtastschaltung (100) nach Anspruch 1, wobei das Flipflop (102) und der n-Bit-Zähler (104) flankengesteuert, insbesondere einflankengesteuert, insbesondere vorderflankengesteuert sind.

3. Abtastschaltung (100) nach Anspruch 1 oder 2, wobei das Flipflop (102) ein D-Flipflop ist.

4. Abtastschaltung (100) nach einem Ansprüche 1 bis 3, wobei das Logik-Gatter ein NOR-Gatter (122) ist, an welchem eingangsseitig die Stellenwert-Bits des Zählwert-Ausgangs (116) anliegen.

5. Abtastschaltung (100) nach einem Ansprüche 1 bis 4, wobei der Zählwert-Ausgang (116) des n-Bit-Zählers (104) über ein weiteres Logik-Gatter (120) mit einem Alarmsignalgeber, der insbesondere eine Anzeigeeinheit (132) umfasst, verbunden ist.

6. Abtastschaltung (100) nach Anspruch 5, wobei das weitere Logik-Gatter (120) ein AND-Gatter ist, an welchem eingangsseitig die Stellenwert-Bits des Zählwert-Ausgangs (116) anliegen.

7. Abtastschaltung (100) nach einem Ansprüche 1 bis 6, wobei das konstante Signal am Data-Eingang (106) des Flipflops (102) ein High-Pegel-Signal ist.

8. Abtastschaltung (100) nach einem Ansprüche 1 bis 7, wobei das Primär-Taktsignal (202) und das Sekundär-Taktsignal (204) im Wesentlichen die gleiche Taktperiodendauer aufweisen.

9. Abtastschaltung (100) nach einem Ansprüche 1 bis 8, wobei n = 2 ist.

10. Kerntechnische Anlage, insbesondere Kernkraftwerk, mit einem Überwachungssystem, welches mehrfach redundant ausgelegte Baugruppen mit jeweils einem Taktgenerator aufweist, wobei zumindest eine Abtastschaltung (100) nach einem der Ansprüche 1 bis 9 vorhanden ist, um zumindest ein von einem der Taktgeneratoren erzeugtes Taktsignal (202, 204) gegenüber einem von einem der anderen Taktgeneratoren erzeugten Taktsignal (202, 204) oder gegenüber einem externen Taktsignal (202, 204) abzutasten und auf Taktausfall zu überwachen.

11. Kerntechnische Anlage nach Anspruch 10, wobei die Taktgeneratoren von gleicher Bauart sind.

12. Kerntechnische Anlage nach Anspruch 10 oder 11, wobei das Überwachungssystem für die Positionsmessung von Kernreaktor-Steuerstäben ausgebildet ist.

## Claims

1. Digital sampling circuit (100) for a secondary clock-pulse signal (204) to be monitored for clock-pulse failure by means of a primary clock-pulse signal (202),
• comprising a flip-flop (102) having
- a clock input (108),
- a data input (106),
- a Q output (110), and
- an asynchronous reset input (112),
• and comprising an n-bit counter (104) having
- a clock-pulse input (114),
- an asynchronous reset input (128), and
- a count-value output (116),
the flip-flop (102) and the n-bit counter (104) being electrically interconnected, and
• n being ≥ 2,
• the primary clock-pulse signal (202) being applied on the clock-pulse input (114) of the n-bit counter (104),
• the secondary clock-pulse signal (204) being applied on the clock input (108) of the flip-flop (102),
• a constant signal being applied on the data input (106) of the flip-flop (102),
• the Q output (110) of the flip-flop (102) being connected to the reset input (128) of the n-bit counter (104), **characterised in that**
• the count-value output (116) of the n-bit counter (104) is connected via an interposed logic gate (122) and a feedback loop (130) to the asynchronous reset input (112) of the flip-flop (102) in such a way that resetting the n-bit counter (104) resets the flip-flop (102).

2. Sampling circuit (100) according to claim 1, wherein the flip-flop (102) and the n-bit counter (104) are edge-triggered, in particular single-edge-triggered, in particular leading-edge-triggered.

3. Sampling circuit (100) according to either claim 1 or claim 2, wherein the flip-flop (102) is a D flip-flop.

4. Sampling circuit (100) according to any of claims 1 to 3, wherein the logic gate is a NOR gate (122), on the input side of which the place value bits of the count value output (116) are applied.

5. Sampling circuit (100) according to any of claims 1 to 4, wherein the count value output (116) of the n-bit counter (104) is connected via an additional logic gate (120) to an alarm-signal transmitter, in particular comprising a display unit (132).

6. Sampling circuit (100) according to claim 5, wherein the additional logic gate (120) is an AND gate, on the input side of which the place value bits of the count value output (116) are applied.

7. Sampling circuit (100) according to any of claims 1 to 6, wherein the constant signal at the data input (106) of the flip-flop (102) is a high-level signal.

8. Sampling circuit (100) according to any of claims 1 to 7, wherein the primary clock-pulse signal (202) and the secondary clock-pulse signal (204) have substantially the same clock-pulse cycle duration.

9. Sampling circuit (100) according to any of claims 1 to 8, wherein n is 2.

10. Nuclear facility, in particular a nuclear power plant, having a monitoring system comprising multi-redundant assemblies , each of which has a clock-pulse generator, wherein at least one sampling circuit (100) according to any of claims 1 to 9 is provided to sample at least one clock-pulse signal (202, 204) generated by one of the clock-pulse generators in comparison with a clock-pulse signal (202, 204) generated by one of the other clock-pulse generators or in comparison with an external clock-pulse signal (202, 204), and to monitor said signal for clock-pulse failure.

11. Nuclear facility according to claim 10, wherein the clock-pulse generators are of identical design.

12. Nuclear facility according to either claim 10 or claim 11, wherein the monitoring system is configured for measuring the position of nuclear-reactor control rods.

## Revendications

1. Circuit de balayage (100) numérique pour un signal d'horloge secondaire (204) dont une panne d'horloge doit être surveillée à l'aide d'un signal d'horloge primaire (202),
• avec une bascule (102), laquelle présente
- une entrée d'horloge (108),
- une entrée de données (106),
- une sortie Q (110) et
- une entrée de réinitialisation (112) asynchrone,
• et avec un compteur de n bits (104), lequel présente
- une entrée d'horloge (114),
- une entrée de réinitialisation (128) asynchrone et
- une sortie de valeur de comptage (116),
dans lequel la bascule (102) et le compteur de n bits (104) sont électriquement connectés l'une à l'autre, et dans lequel
• n ≥ 2,
• le signal d'horloge primaire (202) est présent sur l'entrée d'horloge (114) du compteur de n bits (104),
• le signal d'horloge secondaire (204) est présent sur l'entrée d'horloge (108) de la bascule (102),
• un signal constant est présent sur l'entrée de données (106) de la bascule (102),
• la sortie Q (110) de la bascule (102) est raccordée à l'entrée de réinitialisation (128) du compteur de n bits (104), **caractérisé en ce que**
• la sortie de valeur de comptage (116) du compteur de n bits (104) est raccordée, par le biais d'une porte logique (122) intercalée et d'une boucle de rétroaction (130), à l'entrée de réinitialisation (112) asynchrone de la bascule (102) de telle sorte qu'une réinitialisation du compteur de n bits (104) réinitialise la bascule (102).

2. Circuit de balayage (100) selon la revendication 1, dans lequel la bascule (102) et le compteur de n bits (104) sont commandés sur front, en particulier sont commandés sur front unique, en particulier sont commandés sur front avant.

3. Circuit de balayage (100) selon la revendication 1 ou 2, dans lequel la bascule (102) est une bascule D.

4. Circuit de balayage (100) selon l'une des revendications 1 à 3, dans lequel la porte logique est une porte NON-OU (122) sur laquelle sont présents, côté entrée, les bits de valeur positionnelle de la sortie de valeur de comptage (116).

5. Circuit de balayage (100) selon l'une des revendications 1 à 4, dans lequel la sortie de valeur de comptage (116) du compteur de n bits (104) est, par le biais d'une autre porte logique (120), raccordée à un générateur de signaux d'alarme qui comprend en particulier une unité d'affichage (132).

6. Circuit de balayage (100) selon la revendication 5, dans lequel l'autre porte logique (120) est une porte ET sur laquelle sont présents, côté entrée, les bits de valeur positionnelle de la sortie de valeur de comptage (116).

7. Circuit de balayage (100) selon l'une des revendications 1 à 6, dans lequel le signal constant sur l'entrée de données (106) de la bascule (102) est un signal de niveau haut.

8. Circuit de balayage (100) selon l'une des revendications 1 à 7, dans lequel le signal d'horloge primaire (202) et le signal d'horloge secondaire (204) présentent essentiellement la même durée de période d'horloge.

9. Circuit de balayage (100) selon l'une des revendications 1 à 8, dans lequel n = 2.

10. Installation nucléaire, en particulier centrale nucléaire, avec un système de surveillance qui présente des sous-ensembles conçus avec redondance multiple avec respectivement un générateur d'horloge, dans laquelle il y a au moins un circuit de balayage (100) selon l'une des revendications 1 à 9 pour balayer au moins un signal d'horloge (202, 204) produit par un des générateurs d'horloge par rapport à un signal d'horloge (202, 204) produit par l'un des autres générateurs d'horloge ou par rapport à un signal d'horloge (202, 204) externe et pour en surveiller la panne d'horloge.

11. Installation nucléaire selon la revendication 10, dans laquelle les générateurs d'horloge ont un mode de construction identique.

12. Installation nucléaire selon la revendication 10 ou 11, dans laquelle le système de surveillance est constitué pour la mesure de position de barres de commande de réacteurs nucléaires.
